(19) Europäisches Patentamt
European Patent Office
Office européen des brevets

(11) **EP 4 300 584 A1**

(12) **EUROPEAN PATENT APPLICATION**
published in accordance with Art. 153(4) EPC

(43) Date of publication:
**03.01.2024 Bulletin 2024/01**

(21) Application number: **22778869.2**

(22) Date of filing: **28.03.2022**

(51) International Patent Classification (IPC):
**H01L 27/32** (2006.01)        **H01L 51/56** (2006.01)

(86) International application number:
**PCT/CN2022/083422**

(87) International publication number:
**WO 2022/206687 (06.10.2022 Gazette 2022/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.03.2021  CN 202110342330**

(71) Applicant: **Huawei Technologies Co., Ltd.
Shenzhen, Guangdong 518129 (CN)**

(72) Inventors:
• **HAN, Gangfeng
Shenzhen, Guangdong 518129 (CN)**
• **CHOO, Kyoseop
Shenzhen, Guangdong 518129 (CN)**

(74) Representative: **Gill Jennings & Every LLP
The Broadgate Tower
20 Primrose Street
London EC2A 2ES (GB)**

(54) **DISPLAY PANEL, DISPLAY MODULE, AND ELECTRONIC DEVICE**

(57)    This application provides a display panel, a display module, and an electronic device. The display panel includes a substrate, and a display function film layer and at least one light sensor that are located on the substrate. The display function film layer at least includes a semiconductor layer and a plurality of metal electrode layers that are stacked, and the semiconductor layer has a first P-type lightly doped region and a first P-type heavily doped region. A first doped region, or a second doped region, or both of the light sensor have a same material and same doping concentration as those of the first P-type heavily doped region. When the first P-type heavily doped region is formed, doped regions of the light sensor may be formed simultaneously, without a need of an additional doping process. An input electrode and an output electrode of the light sensor are respectively disposed on a same layer as at least one of the plurality of metal electrode layers. In this way, when the metal electrode layer is formed, patterns of the input electrode and the output electrode are formed simultaneously, without a need of an additional mask process. Therefore, costs of the display panel may be reduced.

FIG. 8

**Description**

**CROSS-REFERENCE TO RELATED APPLICATIONS**

This application claims priority to Chinese Patent Application No. 202110342330.9, filed with the China National Intellectual Property Administration on March 30, 2021 and entitled "DISPLAY PANEL, DISPLAY MODULE, AND ELECTRONIC DEVICE", which is incorporated herein by reference in its entirety.

**TECHNICAL FIELD**

This application relates to the field of display technologies, and in particular, to a display panel, a display module, and an electronic device.

**BACKGROUND**

A light sensor converts an optical signal on a photosensitive surface into an electrical signal in a corresponding proportion to the optical signal by using an optical-to-electrical conversion function of an optoelectronic device. At present, light sensors are widely used in various electronic devices. For example, a light sensor in a mobile phone may be used to detect a lighting condition of a current environment, so that brightness of a display screen may be adjusted to make human eyes comfortable and not dazzling. In addition, the light sensor may also detect light at a specific wavelength (such as red light/green light/blue light/infrared light/ultraviolet light), to implement more functions and applications, such as color temperature detection, proximity light detection, and ultraviolet ray intensity detection.

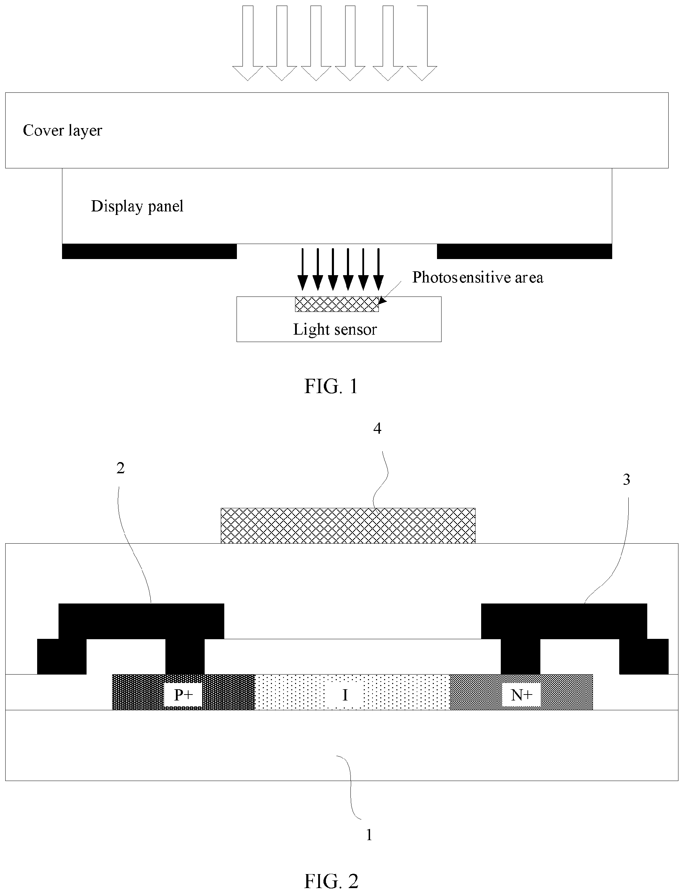

Currently, in a trend of an ultra-high screen-to-body ratio of a full screen, an independent light sensor with a sensor and a chip disposed together is larger in size and cannot be placed in an edge area of a display screen. Therefore, a structure in which the light sensor is placed under a screen is generally used, as shown in FIG. 1. However, in this structure, a more sensitive light sensor is required because a light transmittance is greatly reduced due to blocking by the screen.

Therefore, in a related technology, a solution with a light sensor of a PIN structure integrated into a display screen is proposed, to reduce a quantity of film layers above the light sensor and to improve a transmittance of light output by the light sensor. FIG. 2 shows the PIN structure integrated into the screen. A semiconductor material layer is disposed on a substrate 1 of a display panel, and doping is performed on the semiconductor material layer to form a P-type heavily doped region (P+), an N-type heavily doped region (N+), and an intrinsic light sensitive region (I). The P+ region and the N+ region are respectively connected to a metal electrode 2 and a metal electrode 3, and are respectively used for signal reading and bias voltage input. A gate electrode 4 is located above the metal electrode 2 and the metal electrode 3. Because external light needs to be irradiated to the I region through the gate electrode 4, the gate electrode 4 is prepared by using a transparent conductive material. However, in the related technology, to form the PIN structure, four mask processes need to be added based on an existing display panel manufacturing process, and the four mask processes are: forming the P+ region, forming the N+ region, forming the I region, and forming the gate electrode. Therefore, costs of the display panel are significantly reduced by integrating the PIN structure into the screen.

**SUMMARY**

This application provides a display panel, a display module, and an electronic device, configured to reduce costs of the display panel.

According to a first aspect, an embodiment of this application provides a display panel, including a display substrate and an opposite substrate that are disposed opposite to each other. The display substrate includes a substrate, and a display function film layer and at least one light sensor that are located on the substrate. The display function film layer at least includes a semiconductor layer and a plurality of metal electrode layers that are stacked, and the semiconductor layer has a first P-type lightly doped region and a first P-type heavily doped region. The light sensor includes an input electrode, an output electrode, and a channel region, a first doped region, and a second doped region that are disposed on a same layer as the semiconductor layer. The first doped region and the second doped region are respectively located on two sides of the channel region, the input electrode is electrically connected to the first doped region, and the output electrode is electrically connected to the second doped region. The first doped region has a same material and same doping concentration as those of the first P-type heavily doped region, or the second doped region has a same material and same doping concentration as those of the first P-type heavily doped region, or both the first doped region and the second doped region have a same material and same doping concentration as those of the first P-type heavily doped region. The input electrode and the output electrode are respectively disposed on a same layer as at least one of the plurality of metal electrode layers.

In the display panel provided in this embodiment of this application, the light sensor includes the input electrode, the output electrode, and the channel region, the first doped region, and the second doped region that are disposed on a same layer as the semiconductor layer. The input electrode and the output electrode are respectively disposed on a same layer as at least one of the plurality of metal electrode layers of the display function film layer. When the plurality of metal electrode layers are formed, patterns of the input electrode and the output electrode may be formed simultaneously. In this way, only mask patterns need to be changed when patterns of the metal electrode layers are formed, without a need of an additional mask process. In addition, at least one of the two doped regions of the light sensor has a same material and same doping concentration as those of the first P-type heavily doped region of the display function film layer. When the first P-type heavily doped region is formed, the doped regions of the light sensor may be formed simultaneously, without a need of an additional doping process. At most two mask processes need to be added when the channel region and doped regions are formed for the display panel in this application. Compared with a related technology in which four mask processes need to be added, at least two mask processes may be reduced, and therefore costs of the display panel may be reduced.

It should be noted that the plurality of metal electrode layers of the display function film layer in this application generally include a layer on which a source electrode is located, a layer on which a drain electrode is located, a layer on which a gate electrode is located, and the like. This is not limited herein. The input electrode in this application may be disposed on a same layer as one of the plurality of metal electrode layers, or the input electrode may include a plurality of layers, and each layer is disposed on a same layer as one of the plurality of metal electrode layers. Similarly, the output electrode may be disposed on a same layer as one of the plurality of metal electrode layers, or the output electrode may include a plurality of layers, and each layer is disposed on a same layer as one of the plurality of metal electrode layers. This is not limited herein. It only needs to be ensured that, in this application, the input electrode and the output electrode of the light sensor and the metal electrode layers of the display function film layer are formed by using a same mask process.

To further reduce costs, the channel region of the light sensor may have a same material and same doping concentration as those of the first P-type lightly doped region. In this way, when the first P-type lightly doped region of the display function film layer is formed, the channel region of the light sensor may be formed simultaneously, without a need of an additional doping process and reducing costs.

Certainly, during specific implementation, the channel region of the light sensor may also be made of an intrinsic semiconductor material. This is not limited herein.

In this application, when both the first doped region and the second doped region have a same material and same doping concentration as those of the first P-type heavily doped region, the two doped regions of the light sensor may be formed simultaneously when the first P-type heavily doped region of the display function film layer is formed, without a need of an additional doping process.

Certainly, during specific implementation, when only one of the first doped region and the second doped region has a same material and same doping concentration as those of the first P-type heavily doped region, the other doped region may be set as an N-type doped region. In other words, when the first doped region has a same material and same doping concentration as those of the first P-type heavily doped region, the second doped region is an N-type doped region; or when the second doped region has a same material and same doping concentration as those of the first P-type heavily doped region, the first doped region is an N-type doped region.

It should be noted that, in this application, the gate electrode may be disposed or may not be disposed for the light sensor. This is not limited herein.

For example, the light sensor may further include at least one gate electrode disposed on a same layer as one of the plurality of metal electrode layers. In this way, when the metal electrode layer is formed, the gate electrode may be formed simultaneously by changing only a mask pattern, without a need of an additional mask process. In addition, an orthographic projection of the at least one gate electrode in the channel region partially overlaps the channel region, so that it may be ensured that light may be irradiated to the channel region of the light sensor.

Compared with a case in which no gate electrode is disposed for the light sensor, disposing a gate electrode for the light sensor in this application may narrow the channel region, reduce a resistance of the channel region, and therefore increase a photosensitive current and improve photosensitive efficiency of the light sensor.

During specific implementation, when at least one gate electrode is disposed for the light sensor, a location of each gate electrode is not limited in this application, provided that an overlapping area exists between each gate electrode and the channel region. In this application, an initial current output by the output electrode when the light sensor is not illuminated and an induced current output by the output electrode when the light sensor is illuminated may be adjusted by changing a potential on the gate electrode.

Optionally, in this application, when the light sensor includes one gate electrode, the gate electrode may be disposed on a side close to the output electrode.

A working principle of the light sensor (also referred to as a photodiode) provided in this application is as follows: When there is no light, a reverse current of the channel region is very small (generally less than 0.1 microampere), and is referred to as a dark current. When there is light, photons carrying energy enter the channel region and transfer the energy to bound electrons on a covalent bond, some electrons are free from the covalent bond, and electron-hole pairs are generated, which are referred to as photo-generated carriers. Under a reverse voltage, the electron-hole pairs drift, so that the reverse current becomes larger obviously. Higher light intensity also results in a larger reverse current. When the light sensor works, the electron-hole pairs are formed mainly in an unblocked region (depletion region) of the channel region. A concentration of the formed electron-hole pairs varies depending on intensity of light absorbed. Stronger light indicates a higher concentration of the electron-hole pairs, a smaller equivalent resistance of the depletion region, and a larger output current signal. Light intensity may be obtained by processing the output current signal.

The light sensor in this application features high sensitivity because the resistance of the depletion region is larger, and the dark current (leakage current) is small especially when no light is irradiated. In addition, the dark current may be further adjusted by adjusting the potential on the gate electrode and a voltage difference between the input electrode and the output electrode.

In actual application, the light sensor of the display panel provided in embodiments of this application may be configured to detect intensity of ambient light, or may be configured to detect intensity of light of a specific wavelength (for example, red light/green light/blue light/infrared light/ultraviolet light), to implement some specific functions. For example, screen brightness is adjusted by detecting ambient light. An adjustment principle may be as follows: The light sensor senses light intensity of a surrounding environment, converts an optical signal into an electrical signal, and outputs the electrical signal. An IC processes the output electrical signal, converts a current analog signal into a digital signal, and then reports the digital signal. The digital signal is processed by using an algorithm and then is multiplied by a corresponding coefficient to obtain a brightness value. The brightness value corresponds to a dimming order of a screen. Whether the screen needs to be dimmed is determined through judgment. If dimming is required, a driver chip outputs a corresponding drive current to adjust brightness of a display screen.

During specific implementation, the display panel may include a display area and a non-display area. Pixels for display are disposed in the display area, and a driver circuit and a trace are generally disposed in the non-display area. The light sensor may be disposed in the display area, or may be disposed in the non-display area. This is not limited herein.

During specific implementation, the display substrate may include a plurality of light sensors, and the plurality of light sensors may be all located in the non-display area; or the plurality of light sensors may be all located in the display area; or certainly, some of the plurality of light sensors may be located in the non-display area, and the other part of the plurality of light sensors may be located in the display area. This is not limited herein.

In actual application, in this application, a plurality of light sensors arranged in a matrix may be disposed in the display area, and a touch function may be implemented by detecting light intensity of each light sensor. Alternatively, a plurality of light sensors are disposed in a fingerprint recognition area, and a fingerprint recognition function is implemented by sensing relative light intensity between fingerprint valleys and fingerprint ridges at a fingerprint touch position. Alternatively, at least one light sensor may be disposed on each of two opposite sides of the display panel. A left side and a right side are used as an example. A gesture recognition function may be implemented by detecting time sequences of output signals of the light sensors on the two sides.

According to a second aspect, an embodiment of this application further provides a display module. The display module may include a display panel, a polarizer, and a cover layer that are sequentially stacked. The display panel may be the display panel provided in the first aspect. Costs of the display panel provided in embodiments of this application may be reduced when compared with a display panel provided in a related technology. Therefore, costs of the display module provided in this embodiment of this application may also be reduced.

Optionally, in the display module, the display panel has a display area and a non-display area. A plurality of light sensors are disposed in the non-display area of the display panel. The display module further includes a light shield ink layer that is located between the display panel and the cover layer and at least one light filter film. An orthographic projection of the light shield ink layer on the display panel covers the non-display area, an orthographic projection of each light filter film on the display panel is located in the non-display area, and each light filter film corresponds to at least one light sensor.

The light shield ink layer is used to shield the non-display area of the display panel, the light shield ink layer has at least one first opening and at least one second opening corresponding to each light filter film, and each first opening corresponds to at least one light sensor. Orthographic projections of the light filter films on the display panel cover orthographic projections of the at least one second opening corresponding to the light filter films on the display panel, and the orthographic projections of the light filter films on the display panel do not overlap an orthographic projection of the first opening on the display panel.

Optionally, the at least one light filter film may include at least one yellow light filter film, at least one cyan light filter film, and at least one magenta light filter film. The light shield ink layer specifically has at least one first opening and at least one second opening corresponding to each yellow light filter film, at least one second opening corresponding to each cyan light filter film, and at least one second opening corresponding to each magenta light filter film. An orthographic projection of the yellow light filter film on the display panel covers an orthographic projection of the at least one second opening corresponding to the yellow light filter film on the display panel, an orthographic projection of the cyan light filter film on the display panel covers an orthographic projection of the at least one second opening corresponding to the cyan light filter film on the display panel, and an orthographic projection of the magenta light filter film on the display panel covers an orthographic projection of the at least one second opening corresponding to the magenta light filter film on the display panel, and orthographic projections of the yellow light filter film, the cyan light filter film, and the magenta light filter film on the display panel do not overlap the orthographic projection of the first opening on the display panel. During specific implementation, the light filter film and the light shield ink layer may be disposed on a same layer. Certainly, the light filter film and the light shield ink layer may alternatively be disposed on different layers. This is not limited herein.

For example, every four light sensors may be used as a group of detection units, and at least one group of detection units may be disposed in the non-display area. For each group of detection units, one light sensor corresponds to one first opening, the other three light sensors correspond to three second openings, and the three second openings respectively correspond to one yellow light filter film, one magenta light filter film, and one cyan light filter film. The yellow light filter film may enable yellow light to pass through, the magenta light filter film may enable magenta light to pass through, and the cyan light filter film may enable cyan light to pass through. Therefore, intensity values of B (blue light), G (green light), R (red light), and NIR (infrared light) in ambient light may be calculated by detecting intensity of yellow light, cyan light, magenta light, and white light (that is, light passing through the first opening) in ambient light.

Further, a function of detecting a color temperature of an environment may be further implemented by using the intensity values of B (blue light), G (green light), and R (red light).

Compared with direct detection of the intensity values of B (blue light), G (green light), and R (red light) in ambient light, calculation of the intensity values of B (blue light), G (green light), and R (red light) in ambient light by detecting intensity of yellow light, cyan light, magenta light, and white light in ambient light in this application can improve a low illumination detection capability by more than two times. Therefore, in this application, yellow, cyan, and magenta are used to replace red, blue, and green as measurement channels for a color temperature of an environment, so that an amount of light entering the light sensor may be increased by two times or more, thereby improving a sensing capability of the display module in low illumination.

In addition, in this application, no infrared light channel needs to be manufactured, a quantity of light sensors and a quantity of analog-to-digital conversion channels of a chip may be reduced, and a process of manufacturing an infrared light filter film is not required, thereby reducing manufacturing complexity and costs of the display module.

Optionally, the display module may further include a first quarter-wavelength delay layer and a second quarter-wavelength delay layer that are respectively located on two sides of the polarizer. When external ambient light passes through the polarizer and becomes linear polarized light, the linear polarized light needs to pass through the second quarter-wavelength delay layer twice after being reflected by a backplane of the display panel and then illuminated to the polarizer, so that a polarization direction of the linear polarized light is perpendicular to a polarization direction of the polarizer, and the reflected linear polarized light cannot pass through the polarizer, thereby reducing reflectivity of the display module. Similarly, after light emitted by the display panel is converted into linear polarized light by using the polarizer, light reflected by an object (for example, a face) also needs to pass through the first quarter-wavelength delay layer twice, so that the polarization direction of the linear polarized light is perpendicular to the polarization direction of the polarizer, and the reflected linear polarized light cannot pass through the polarizer. This prevents the light emitted by the display panel from being illuminated to the light sensor after the light is reflected by an object, which consequently causes a measurement error because the measured value deviates from a real environment.

For example, the display module may further include a touch layer located between the display panel and the cover layer. During specific implementation, the touch layer may be disposed between the display panel and the polarizer. This is not limited herein.

According to a third aspect, an embodiment of this application further provides an electronic device, which may include the display module provided in the second aspect. A problem-resolving principle of the electronic device is similar to that of one of the foregoing display modules. Therefore, implementation of the electronic device may refer to implementation of the foregoing display module, and details are not described again.

During specific implementation, the electronic device in this application may detect a lighting condition of a current environment by using a light sensor integrated into a display panel, to adjust screen brightness of the display panel, make human eyes comfortable and not dazzling, and reduce power consumption of a display screen. For example, the electronic device is a mobile phone, a tablet, a portable computer, a display, or a television. The electronic device may further detect light at a specific wavelength (for example, red light/green light/blue light/infrared light/ultraviolet light) by using the light sensor integrated into the display panel, to implement more functions and applications, for example, color temperature detection, proximity light detection, and ultraviolet ray intensity detection. For example, a mobile phone, a tablet, a watch, a computer, a monitoring screen, or a television senses light (for example, ultraviolet light/infrared light) of a specific wavelength in external ambient light, to implement a specific function. For example, infrared sensing may be used for proximity sensing, and ultraviolet sensing may be used to implement a UV index sensor.

**BRIEF DESCRIPTION OF DRAWINGS**

FIG. 1 is a schematic diagram of a position of a light sensor of a display panel according to a related technology;
FIG. 2 is a schematic diagram of a structure of a light sensor of a display panel according to a related technology;
FIG. 3 is a schematic diagram of an application scenario according to an embodiment of this application;
FIG. 4 is a schematic diagram of another application scenario according to an embodiment of this application;
FIG. 5 is a schematic diagram of still another application scenario according to an embodiment of this application;
FIG. 6 is a schematic diagram of a structure of an LCD panel according to an embodiment of this application;
FIG. 7 is a schematic diagram of a structure of an AMOLED display panel according to an embodiment of this application;
FIG. 8 is a schematic diagram of a structure of a display panel according to an embodiment of this application;
FIG. 9 is a schematic diagram of a structure of a display panel according to another embodiment of this application;
FIG. 10 is a schematic diagram of a structure of a display panel according to still another embodiment of this application;
FIG. 11 is a schematic diagram of a working principle of a light sensor according to an embodiment of this application;
FIG. 12 is a schematic diagram of an equivalent circuit of a light sensor according to an embodiment of this application;
FIG. 13 is a schematic diagram of a partial structure of a display panel according to an embodiment of this application;
FIG. 14 is a schematic diagram of a partial structure of a display panel according to another embodiment of this application;
FIG. 15 is a schematic diagram of a partial structure of a display panel according to still another embodiment of this application;
FIG. 16 is a schematic diagram of a working principle of adjusting display brightness of a display panel based on a light sensor according to this application;
FIG. 17 is a schematic diagram of a structure of a display panel according to still another embodiment of this application;
FIG. 18 is a schematic diagram of a structure of a display panel according to still another embodiment of this application;
FIG. 19 is a schematic diagram of a structure of a display panel according to still another embodiment of this application;
FIG. 20 is a time sequence diagram of an output signal of a light sensor of the display panel shown in FIG. 19;
FIG. 21 is a schematic diagram of a cross-sectional structure of a display module according to an embodiment of this application;
FIG. 22 is a schematic diagram of a top-view structure of a display module according to an embodiment of this application;
FIG. 23 is a schematic diagram of a cross-sectional structure of the display module shown in FIG. 22 along an AA' direction;
FIG. 24 is a schematic diagram of a cross-sectional structure of the display module shown in FIG. 22 along a BB' direction;
FIG. 25 is a schematic diagram of another cross-sectional structure of the display module shown in FIG. 22 along a BB' direction;
FIG. 26 is a schematic curve of a transmittance and a wavelength of a light filter film according to an embodiment of this application;
FIG. 27 is a schematic diagram of a structure of a display module according to an embodiment of this application; and
FIG. 28 is a schematic diagram of a cross-sectional structure of a display module according to still another embodiment of this application.

**DESCRIPTION OF EMBODIMENTS**

To make the objectives, technical solutions, and advantages of this application clearer, the following further describes this application in detail with reference to the accompanying drawings.

To facilitate understanding of a display panel provided in embodiments of this application, the following first describes an application scenario of the display panel.

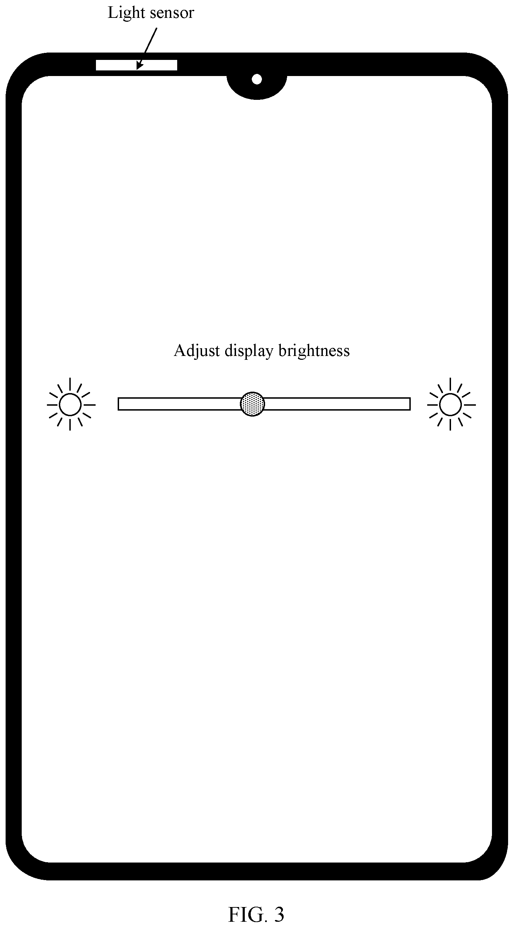

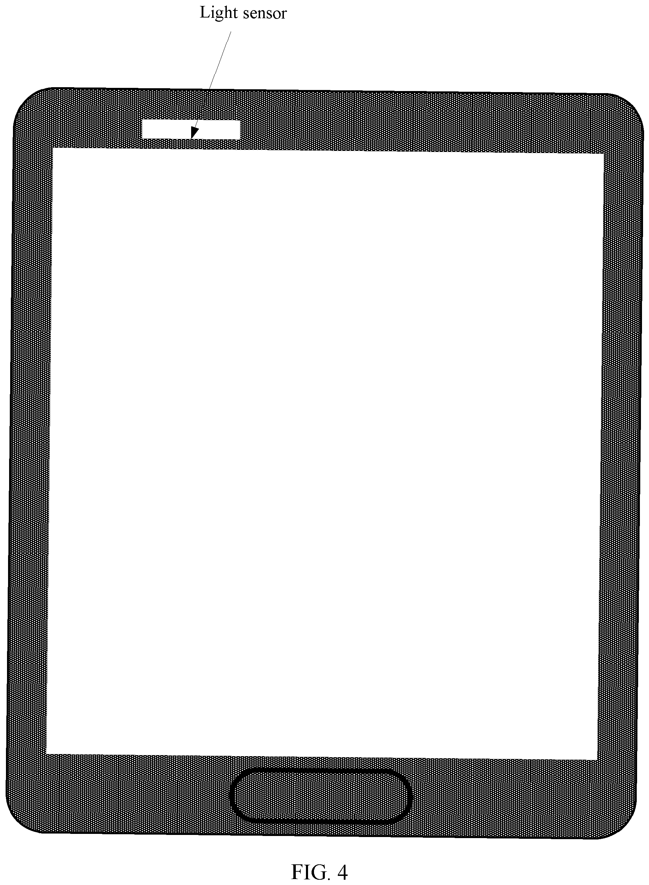

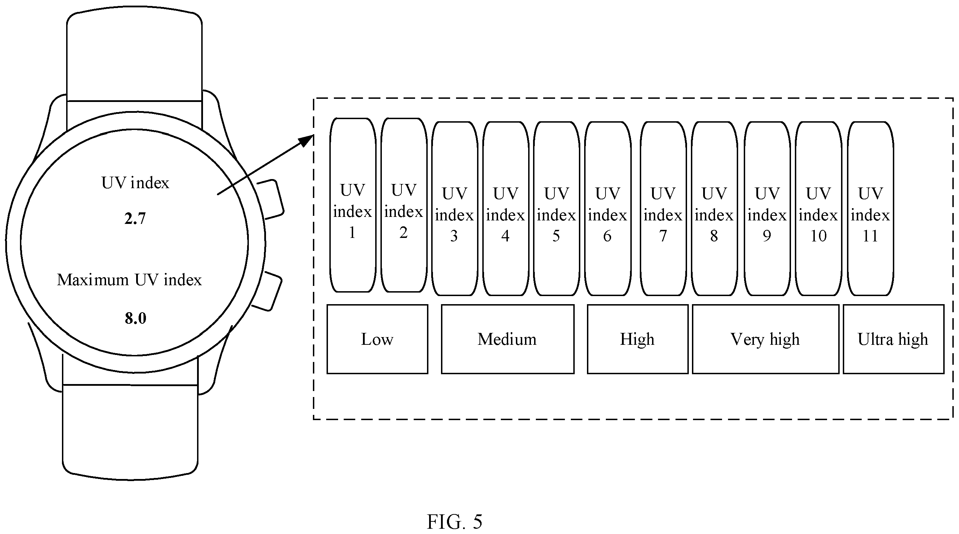

This application may be applied to any electronic device that combines a light sensor and the display panel. In one application scenario, the electronic device may detect a lighting condition of a current environment by using the light sensor integrated into the display panel, to adjust screen brightness of the display panel, make human eyes comfortable and not dazzling, and reduce power consumption of a display screen. For example, the electronic device is a mobile phone shown in FIG. 3, or a tablet, a portable computer, a display, a television, or the like shown in FIG. 4. In another application scenario, the electronic device may detect light at a specific wavelength (for example, red light/green light/blue light/infrared light/ultraviolet light) by using the light sensor integrated into the display panel, to implement more functions and applications, for example, color temperature detection, proximity light detection, and ultraviolet ray intensity detection. For example, a mobile phone, a tablet, or a watch, a computer, a monitoring screen, or a television shown in FIG. 5 senses light (for example, ultraviolet light/infrared light) of a specific wavelength in external ambient light, to implement a specific function. For example, infrared sensing may be used for proximity sensing, and ultraviolet sensing may be used to implement a UV index sensor.

However, in a related technology, in a display panel that belongs to a screen and that is integrated with a light sensor, the light sensor is of a PIN structure. Refer to FIG. 2. During manufacturing, a semiconductor material layer on a substrate 1 of the display panel is doped to form a P-type heavily doped region (P+), an N-type heavily doped region (N+), and an intrinsic light sensitive region (I) that are of the PIN structure. The P+ region and the N+ region are connected to a metal electrode 2 and a metal electrode 3, respectively, and are used for signal reading and bias voltage input, respectively. A gate electrode 4 is located above the metal electrode 2 and the metal electrode 3. Because external light needs to be irradiated to the I region through the gate electrode 4, the gate electrode 4 is prepared by using a transparent conductive material. However, in the related technology, to form the PIN structure, four mask processes need to be added based on an existing display panel manufacturing process, and the four mask processes are: forming the P+ region, forming the N+ region, forming the I region, and forming the gate electrode. Therefore, costs of the display panel are significantly reduced by integrating the PIN structure into the screen.

Therefore, an embodiment of this application provides a display panel that belongs to a screen and that is integrated with a light sensor. Manufacturing costs of the display panel is reduced by changing a structure of the light sensor of the screen.

To facilitate understanding of the technical solutions of this application, the following specifically describes a flexible display provided in this application with reference to the accompanying drawings and specific implementations.

Terms used in the following embodiments are merely intended to describe specific embodiments, but are not intended to limit this application. As used in this specification and appended claims of the application, singular expressions "one", "a", "the foregoing", "the", and "the one" are also intended to include expressions such as "one or more", unless the contrary is clearly indicated in the context. It should be further understood that in the following embodiments of this application, "at least one" and "one or more" refer to one, two, or more. The term "and/or" is used to describe an association relationship between associated objects and represents that three relationships may exist. For example, A and/or B may represent the following cases: Only A exists, both A and B exist, and only B exists, where A and B may be singular or plural. A character "/" generally indicates an "or" relationship between the associated objects.

Reference to "an embodiment", "some embodiments", or the like described in this specification indicates that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily mean reference to a same embodiment. Instead, the statements mean "one or more but not all of embodiments", unless otherwise specifically emphasized in another manner. The terms "include", "comprise", "have", and their variants all mean "include but are not limited to", unless otherwise specifically emphasized in another manner.

For ease of understanding of the display panel that belongs to a screen and that is integrated with a light sensor provided in this application, the following first describes a structure of a conventional display panel.

The conventional display panel mainly includes a display substrate and an opposite substrate. The display substrate mainly includes a substrate and a display function film layer disposed on the substrate. The display function film layer includes a plurality of film layers. Display function film layers of display panels of different types and different functions are different. The following uses an example in which the display panel is a liquid crystal display (Liquid Crystal Display, LCD) panel or an active matrix organic light emitting diode (Active Matrix Organic Light Emitting Diode, AMOLED) display panel for description.

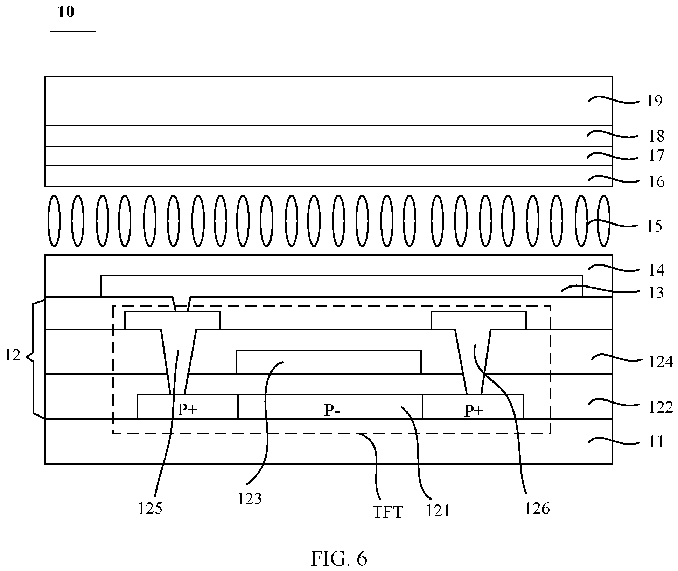

FIG. 6 is a schematic diagram of a structure of an LCD panel according to an embodiment of this application. An LCD panel 10 mainly includes a substrate 11, a circuit film layer 12, a pixel electrode layer 13, a lower alignment film layer 14, a liquid crystal layer 15, an upper alignment film layer 16, a common electrode layer 17, a color filter layer 18, an opposite substrate 19, and the like. The substrate 11 and the opposite substrate 19 may be made of a transparent material, for example, glass. The circuit film layer 12, the pixel electrode layer 13, the lower alignment film layer 14, the liquid crystal layer 15, the upper alignment film layer 16, the common electrode layer 17, and the color filter layer 18 may be collectively referred to as a display function film layer. It should be noted herein that structures of display function film layers of different types of LCD panels may also be different. FIG. 6 is merely an example of one of the LCD panels.

In the LCD panel, a thin film transistor (Thin Film Transistor, TFT) and various traces are mainly disposed on the circuit film layer 12. For example, as shown in FIG. 6, the circuit film layer 12 may include a semiconductor layer 121, a first insulation layer 122, a gate electrode 123, a second insulation layer 124, a source electrode 125, and a drain electrode 126. The semiconductor layer 121 may be made of a semiconductor material, such as amorphous silicon/polycrystalline silicon/oxide. An electrode contact region and a channel region of the TFT may be formed by performing doping using different materials and different concentrations on the semiconductor layer 121. The electrode contact region is generally a P-type heavily doped region (P+), and the channel region is generally a P-type lightly doped region (P-). Both the source electrode 125 and the drain electrode 126 of the TFT are electrically connected to the electrode contact region.

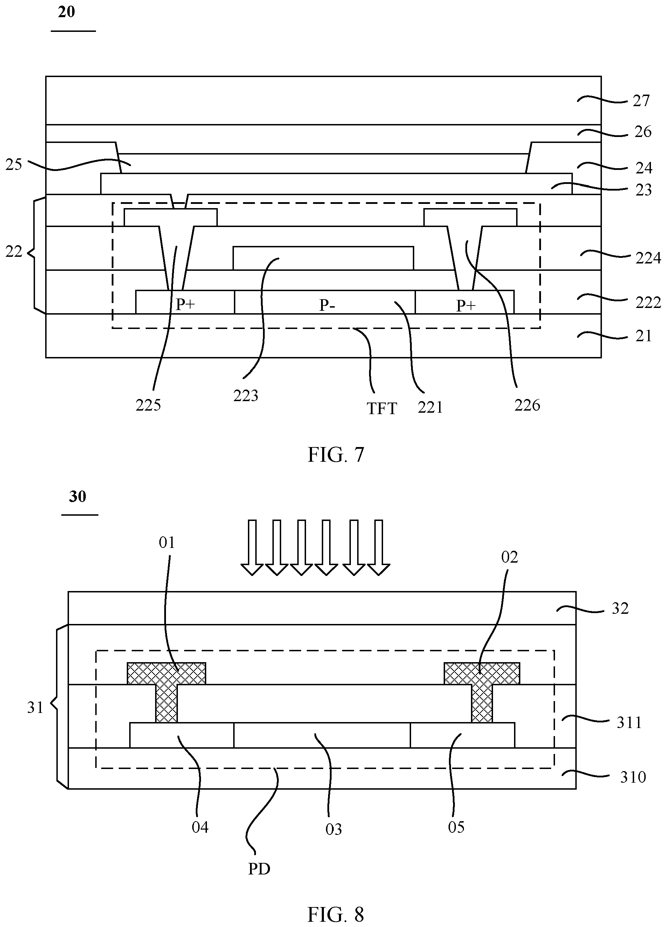

FIG. 7 is a schematic diagram of a structure of an AMOLED display panel according to an embodiment of this application. An AMOLED display panel 20 mainly includes a substrate 21, a circuit film layer 22, an anode layer 23, a pixel limit layer 24, a light emitting layer 25, a cathode layer 26, an opposite substrate 27, and the like. The substrate 21 and the opposite substrate 27 may be formed by using a transparent material, may be rigid substrates such as glass, or may be flexible substrates such as polyimide (PI) or polycarbonate (PC). This is not limited herein. The circuit film layer 22, the anode layer 23, the pixel limit layer 24, the light emitting layer 25, and the cathode layer 26 may be collectively referred to as a display function film layer. It should also be noted herein that structures of display function film layers of AMOLED display panels of different types may also be different. FIG. 7 is only an example of an AMOLED display panel among OLEDs that produce color light. For example, on some AMOLED display panels, if light emitted by a light emitting layer is white light, a color filter layer is generally further disposed above the light emitting layer. Details are not described herein.

In the AMOLED display panel, a TFT and various traces are also disposed on the circuit film layer 22. For example, as shown in FIG. 7, the circuit film layer 22 may include a semiconductor layer 221, a first insulation layer 222, a gate electrode 223, a second insulation layer 224, a source electrode 225, and a drain electrode 226. The semiconductor layer 221 may be made of a semiconductor material such as amorphous silicon/polycrystalline silicon/oxide. An electrode contact region and a channel region of the TFT may be formed by performing doping using different materials and different concentrations on the semiconductor layer 221. The electrode contact region is generally a P-type heavily doped region (P+), and the channel region is generally a P-type lightly doped region (P-). Both the source electrode 225 and the drain electrode 226 of the TFT are electrically connected to the electrode contact region.

The circuit film layer having the TFT is disposed in both the LCD panel and the AMOLED display panel. Because the semiconductor layer and different doped regions located on the semiconductor layer are disposed in the foregoing display panels, a mask process of an existing display panel may be used as much as possible to form the light sensor integrated into the display panel in this application, to reduce a quantity of added mask processes. The following uses an example in which the display panel is an LCD panel or an AMOLED display panel to describe the display panel that belongs to a screen and that is integrated with a light sensor provided in this application.

FIG. 8 is a schematic diagram of a structure of a display panel that belongs to a screen and that is integrated with a light sensor according to an embodiment of this application. A display panel 30 provided in this embodiment of this application includes a display substrate 31 and an opposite substrate 32 that are disposed opposite to each other. The display substrate 31 includes a substrate 310, and a display function film layer (not shown in the figure) and at least one light sensor PD that are located on the substrate 310. The display function film layer may at least include a semiconductor layer and a plurality of metal electrode layers that are stacked, and the semiconductor layer has a first P-type lightly doped region (P-) and a first P-type heavily doped region (P+). The light sensor PD may include an input electrode 01, an output electrode 02, and a channel region 03, a first doped region 04, and a second doped region 05 that are disposed on a same layer as the semiconductor layer. The first doped region 04 and the second doped region 05 are located on two sides of the channel region 03, respectively, the input electrode 01 is electrically connected to the first doped region 04, and the output electrode 02 is electrically connected to the second doped region 05. The first doped region 04 has a same material and same doping concentration as those of the first P-type heavily doped region (P+), or the second doped region 05 has a same material and same doping concentration as those of the first P-type heavily doped region (P+), or both the first doped region 04 and the second doped region 05 have a same material and same doping concentration as those of the first P-type heavily doped region (P+). The input electrode 01 and the output electrode 02 may be respectively disposed on a same layer as at least one of the plurality of metal electrode layers. In FIG. 8, an example in which the input electrode 01 and the output electrode 02 are respectively disposed on a same layer as one of the plurality of metal electrode layers is used for illustration.

In the display panel provided in this embodiment of this application, the light sensor PD includes the input electrode 01, the output electrode 02, and the channel region 03, the first doped region 04, and the second doped region 05 that are disposed on a same layer as the semiconductor layer. The input electrode 01 and the output electrode 02 are respectively disposed on a same layer as at least one of the plurality of metal electrode layers of the display function film layer. When the plurality of metal electrode layers are formed, patterns of the input electrode 01 and the output electrode 02 may be formed simultaneously. In this way, only mask patterns need to be changed when patterns of the metal electrode layers are formed, without a need of an additional mask process. In addition, at least one of the two doped regions 04 and 05 of the light sensor PD has a same material and same doping concentration as those of the first P-type heavily doped region (P+) of the display function film layer. When the first P-type heavily doped region (P+) is formed, the doped regions of the light sensor may be formed simultaneously, without a need of an additional doping process. At most two mask processes need to be added when the channel region and doped regions are formed for the display panel in this application. Compared with a related technology in which four mask processes need to be added, at least two mask processes may be reduced, and therefore costs of the display panel may be reduced.

It should be noted that the plurality of metal electrode layers of the display function film layer in this application may include a layer on which a source electrode is located, a layer on which a drain electrode is located, a layer on which a gate electrode is located, and the like. This is not limited herein. The input electrode in this application may be disposed on a same layer as one of the plurality of metal electrode layers, or the input electrode may include a plurality of layers, and each layer is disposed on a same layer as one of the plurality of metal electrode layers. Similarly, the output electrode may be disposed on a same layer as one of the plurality of metal electrode layers, or the output electrode may include a plurality of layers, and each layer is disposed on a same layer as one of the plurality of metal electrode layers. This is not limited herein. It only needs to be ensured that, in this application, the input electrode and the output electrode of the light sensor and the metal electrode layers of the display function film layer are formed by using a same mask process.

To further reduce costs, the channel region of the light sensor may have a same material and same doping concentration as those of the first P-type lightly doped region (P-). In this way, when the first P-type lightly doped region (P-) of the display function film layer is formed, the channel region of the light sensor may be formed simultaneously, without a need of an additional doping process and reducing costs. During specific implementation, the doping concentration of the channel region may be set to less than $1 \times 10^{13}/cm^3$. This is not limited herein.

Certainly, during specific implementation, the channel region of the light sensor may also be made of an intrinsic semiconductor material (I). This is not limited herein.

In this application, when both the first doped region and the second doped region have a same material and same doping concentration as those of the first P-type heavily doped region (P+), the two doped regions of the light sensor may be formed simultaneously when the first P-type heavily doped region (P+) of the display function film layer is formed, without a need of an additional doping process. During specific implementation, the doping concentration of the first doped region and the second doped region may be set to greater than $1 \times 10^{13}/cm^3$. This is not limited herein.

Certainly, during specific implementation, when only one of the first doped region and the second doped region has a same material and same doping concentration as those of the first P-type heavily doped region (P+), the other doped region may be set as an N-type doped region. In other words, when the first doped region has a same material and same doping concentration as those of the first P-type heavily doped region (P+), the second doped region is an N-type doped region (N+); or when the second doped region has a same material and same doping concentration as those of the first P-type heavily doped region (P+), the first doped region is an N-type doped region (N+).

It should be noted that, in this application, the gate electrode may be disposed or may not be disposed for the light sensor. This is not limited herein.

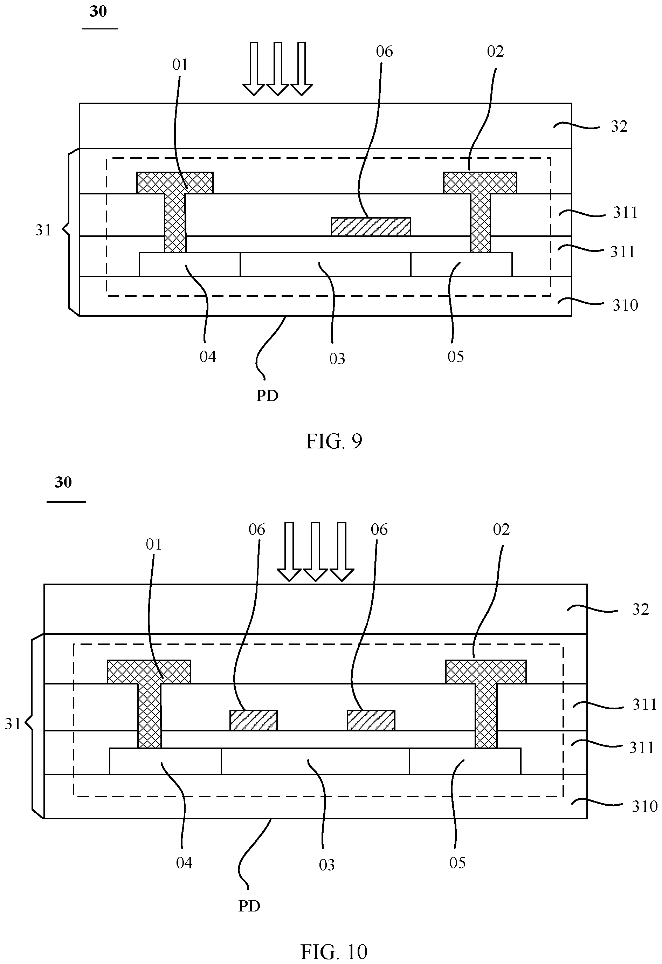

Refer to FIG. 9 and FIG. 10. For example, the light sensor PD may further include at least one gate electrode 06 disposed on a same layer as one of the plurality of metal electrode layers. For example, one gate electrode is used as an example for illustration in FIG. 9, and two gate electrodes are used as an example for illustration in FIG. 10. In this way, when the metal electrode layer is formed, the gate electrode 06 can be formed simultaneously by changing only mask patterns, no additional mask process is required. In addition, an orthographic projection of the at least one gate electrode 06 in the channel region 03 partially overlaps the channel region 03, so that light may be irradiated to the channel region 03 of the light sensor PD.

Compared with a case in which no gate electrode is disposed for the light sensor, disposing a gate electrode for the light sensor in this application may narrow the channel region, reduce a resistance of the channel region, and therefore increase a photosensitive current and improve photosensitive efficiency of the light sensor.

During specific implementation, when at least one gate electrode is disposed for the light sensor, a location of each gate electrode is not limited in this application, provided that an overlapping area exists between each gate electrode and the channel region. In this application, an initial current output by the output electrode when the light sensor is not illuminated and an induced current output by the output electrode when the light sensor is illuminated may be adjusted by changing a potential on the gate electrode.

Refer to FIG. 9. Optionally, in this application, when the light sensor PD includes one gate electrode 06, the gate electrode 06 may be disposed on a side close to the output electrode 02.

During specific implementation, the display panel may further include insulation layers located between the semiconductor layer and the metal electrode layer and between different metal electrode layers. The insulation layer may be made of silicon nitride (SiNx), silicon oxide (SiOx), or a combination thereof. This is not limited herein. For example, in FIG. 8, an insulation layer 311 is located between the channel region 03 (a layer on which the semiconductor layer is located) and the input electrode 01 (a layer on which a metal electrode layer is located). In FIG. 9 and FIG. 10, an insulation layer 11 is located between the channel region 03 (a layer on which the semiconductor layer is located) and the gate electrode 06 (a layer on which a metal electrode layer is located), and is located between the gate electrode 06 (a layer on which a metal electrode layer is located) and the input electrode 01 (a layer on which another metal electrode layer is located).

The following describes this application in detail by using an example in which the plurality of metal electrode layers of the display panel include a first metal electrode layer and a second metal electrode layer. It should be noted that the following embodiments are merely intended to better explain the technical solutions of this application, but do not limit the protection scope of this application.

During specific implementation, the second metal electrode layer is generally used to form a gate electrode of a TFT, the first metal electrode layer is used to form a source electrode and a drain electrode of the TFT, and the second metal electrode layer may be disposed between the first metal electrode layer and the semiconductor layer. Certainly, in some embodiments, the second metal electrode layer may be alternatively located above the first metal electrode layer. This is not limited in this application.

For example, an example in which the second metal electrode layer is located between the first metal electrode layer and the semiconductor layer is used. Still refer to FIG. 9 and FIG. 10. The insulation layer 311 is disposed between the gate electrode 06 (that is, a layer on which the second metal electrode layer is located) and the input electrode 01 (that is, a layer on which the first metal electrode layer is located), and between the input electrode 01 and the channel region 03.

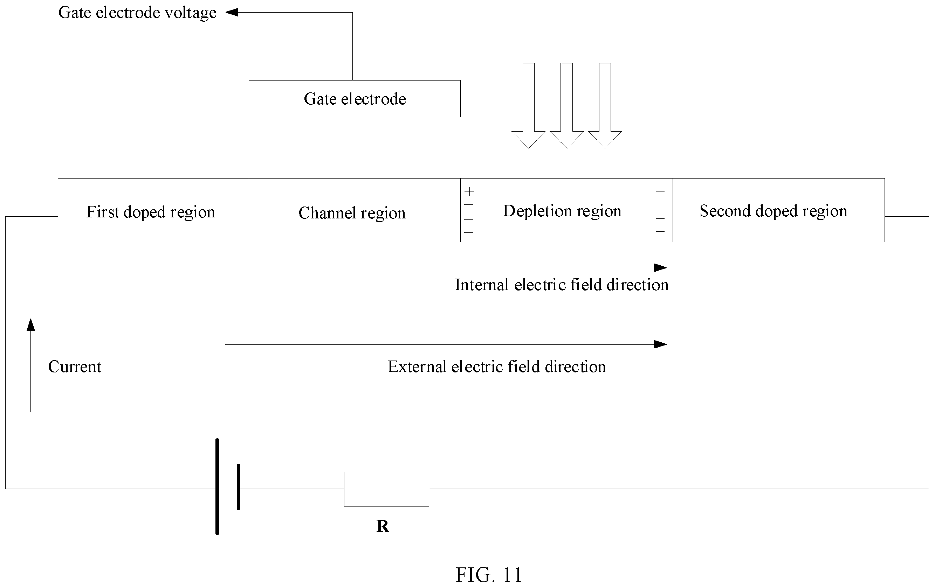

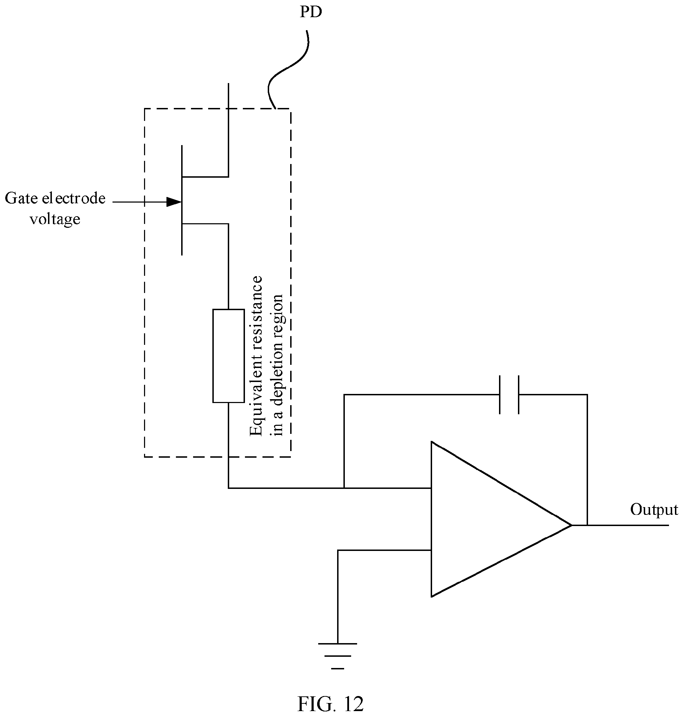

Refer to FIG. 11. A working principle of the light sensor (also referred to as a photodiode) provided in this application is as follows: When there is no light, a reverse current of the channel region is very small (generally less than 0.1 microampere), and is referred to as a dark current. When there is light, photons carrying energy enter the channel region and transfer the energy to bound electrons on a covalent bond, some electrons are free from the covalent bond, and electron-hole pairs are generated, which are referred to as photo-generated carriers. Under a reverse voltage, the electron-hole pairs drift, so that the reverse current becomes larger obviously. Higher light intensity also results in a larger reverse current. When the light sensor works, the electron-hole pairs are formed mainly in an unblocked region (depletion region) of the channel region. A concentration of the formed electron-hole pairs varies depending on intensity of light absorbed. FIG. 12 shows an equivalent circuit diagram. When light is irradiated, stronger light indicates a higher concentration of the electron-hole pairs, a smaller equivalent resistance of the depletion region, and a larger output current signal. Light intensity may be obtained by processing the output current signal.

The light sensor in this application features high sensitivity because the resistance of the depletion region is larger, and the dark current (leakage current) is small especially when no light is irradiated. In addition, the dark current may be further adjusted by adjusting the potential on the gate electrode and a voltage difference between the input electrode and the output electrode.

The following describes in detail the display panel provided in this application with reference to a manufacturing method.

Example 1

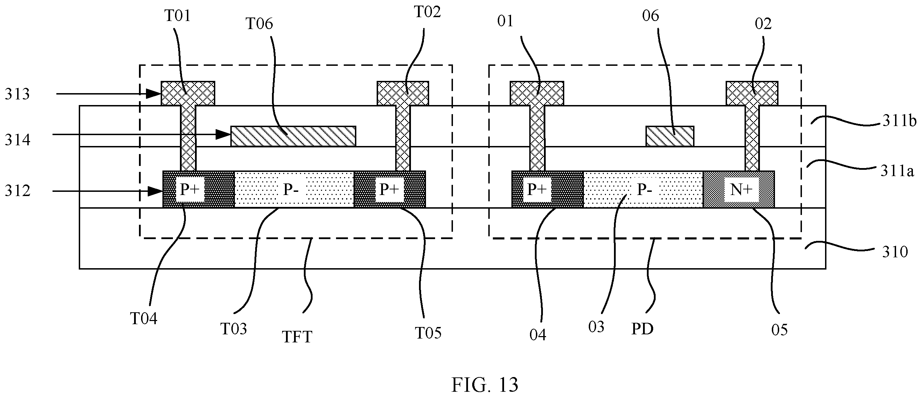

Refer to FIG. 13. A light sensor PD includes an input electrode 01, an output electrode 02, and a channel region 03, a first doped region 04, a second doped region 05, and at least one gate electrode 06 that are disposed on a same layer as a semiconductor layer 312. Certainly, the gate electrode 06 may alternatively not be included. In FIG. 13, one gate electrode is used as an example for illustration. Both the input electrode 01 and the output electrode 02 are disposed on a same layer as a first metal electrode layer 313, the at least one gate electrode 06 is disposed on a same layer as a second metal electrode layer 314, the first doped region 04 has a same material and same doping concentration as those of a first P-type heavily doped region (P+), and the second doped region may be an N-type doped region (N+). The channel region 03 may have a same material and same doping concentration as those of a first P-type lightly doped region (P-).

With the light sensor PD shown in FIG. 13 as an example, a method for preparing the light sensor PD may include the following steps:

Step S101: Form the semiconductor layer 312 on a substrate 310, and perform P-type light doping on the semiconductor layer 312 by using a mask process, to form a channel region T03 of a TFT and the channel region 03 of the light sensor PD.

The semiconductor layer may be made of a semiconductor material such as amorphous silicon, polycrystalline silicon, or oxide. This is not limited herein.

Step S102: Sequentially form a first insulation layer 311a and the second metal electrode layer 314, perform patterning on the second metal electrode layer 314 by using a mask process to form a gate electrode T06 and a channel shield layer of the TFT, and perform P-type heavy doping on the semiconductor layer 312 by using the gate electrode T06 and the channel shield layer of the TFT as shields, to form electrode contact regions T04 and T05 of the TFT and the first doped region 04 of the light sensor PD.

Step S103: Perform patterning on the channel shield layer by using a mask process to form the gate electrode 06 of the light sensor PD.

Step S104: Perform N-type doping on the semiconductor layer 312 by using a mask process to form the second doped region 05 of the light sensor PD.

Step S105: Sequentially form a second insulation layer 311b and the first metal electrode layer 313, and perform patterning on the first metal electrode layer 313 by using a mask process to form a source electrode T01 and a drain electrode T02 of the TFT and the input electrode 01 and the output electrode 02 of the light sensor PD.

In the display panel, to form a photosensitive device PD, step S103 and step S104 need to be added based on an original display panel process. Therefore, two mask processes need to be added. In a related technology, four mask processes need to be added. In comparison, two mask processes may be reduced in this application, thereby reducing production costs.

Example 2

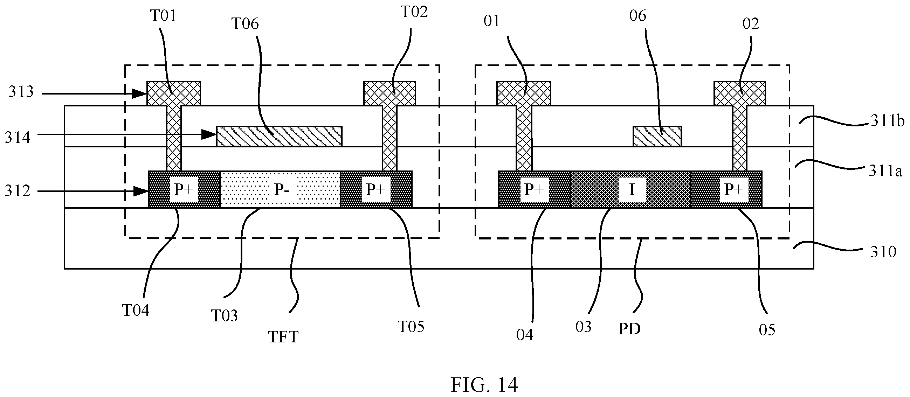

Refer to FIG. 14. A light sensor PD includes an input electrode 01, an output electrode 02, and a channel region 03, a first doped region 04, a second doped region 05, and at least one gate electrode 06 that are disposed on a same layer as a semiconductor layer 312. Certainly, the gate electrode 06 may alternatively not be included. In FIG. 14, one gate electrode is used as an example for illustration. Both the input electrode 01 and the output electrode 02 are disposed on a same layer as a first metal electrode layer 313, the at least one gate electrode 06 is disposed on a same layer as a second metal electrode layer 314, and both the first doped region 04 and the second doped region 05 may have a same material and same doping concentration as those of a first P-type heavily doped region (P+). The channel region 03 may be made of a semiconductor intrinsic material.

With the light sensor PD shown in FIG. 14 as an example, a method for preparing the light sensor PD may include the following steps:

Step S201: Form the semiconductor layer 312 on a substrate 310, perform P-type light doping on the semiconductor layer 312 by using a mask process to form a channel region T03 of a TFT, and form a semiconductor intrinsic material, that is, the channel region 03 of the light sensor PD, by using another mask process.

The semiconductor layer may be made of a semiconductor material such as amorphous silicon, polycrystalline silicon, or oxide. This is not limited herein.

Step S202: Sequentially form a first insulation layer 311a and the second metal electrode layer 314, perform patterning on the second metal electrode layer 314 by using a mask process to form a gate electrode T06 and a channel shield layer of the TFT, and perform P-type heavy doping on the semiconductor layer 312 by using the gate electrode T06 and the channel shield layer of the TFT as shields, to form electrode contact regions T04 and T05 of the TFT and the first doped region 04 and the second doped region 05 of the light sensor PD.

Step S203: Perform patterning on the channel shield layer by using a mask process to form the gate electrode 06 of the light sensor PD.

Step S204: Sequentially form a second insulation layer 311b and the first metal electrode layer 313, and perform patterning on the first metal electrode layer 313 by using a mask process to form a source electrode T01 and a drain electrode T02 of the TFT and the input electrode 01 and the output electrode 02 of the light sensor PD.

In the display panel, to form a photosensitive device PD, a mask process of forming the channel region 03 of the light sensor PD in step S201 and a mask process in step S204 need to be added on the basis of an original display panel process. In a related technology, four mask processes need to be added. In comparison, two mask processes may be reduced in this application, thereby reducing production costs.

Example 3:

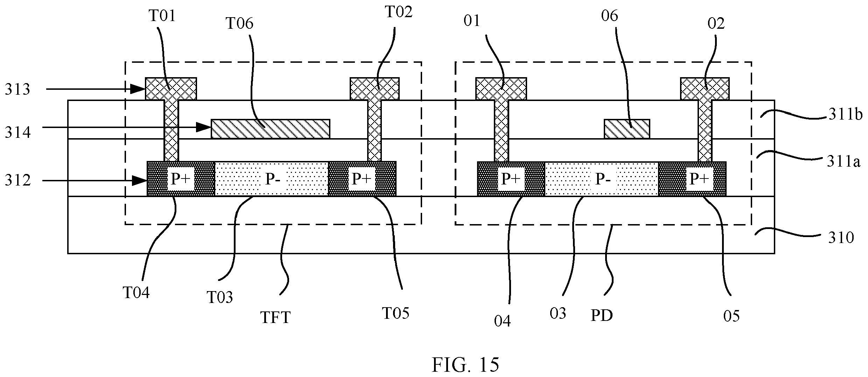

Refer to FIG. 15. A light sensor PD includes an input electrode 01, an output electrode 02, and a channel region 03, a first doped region 04, a second doped region 05, and at least one gate electrode 06 that are disposed on a same layer as a semiconductor layer 312. Certainly, the gate electrode 06 may alternatively not be included. In FIG. 15, one gate electrode is used as an example for illustration. Both the input electrode 01 and the output electrode 02 are disposed on a same layer as a first metal electrode layer 313, the at least one gate electrode 06 is disposed on a same layer as a second metal electrode layer 314, and both the first doped region 04 and the second doped region 05 have a same material and same doping concentration as those of a first P-type heavily doped region (P+). The channel region 03 may have a same material and same doping concentration as those of a first P-type lightly doped region (P-).

With the light sensor PD shown in FIG. 15 as an example, a method for preparing the light sensor PD may include the following steps:

Step S301: Form the semiconductor layer 312 on a substrate 310, and perform P-type light doping on the semiconductor layer 312 by using a mask process, to form a channel region T03 of a TFT and the channel region 03 of the light sensor PD.

The semiconductor layer may be made of a semiconductor material such as amorphous silicon, polycrystalline silicon, or oxide. This is not limited herein.

Step S302: Sequentially form a first insulation layer 311a and the second metal electrode layer 314, perform patterning on the second metal electrode layer 314 by using a mask process to form a gate electrode T06 and a channel shield layer of the TFT, and perform P-type heavy doping on the semiconductor layer 312 by using the gate electrode T06 and the channel shield layer of the TFT as shields, to form electrode contact regions T04 and T05 of the TFT and the first doped region 04 and the second doped region 05 of the light sensor PD.

Step S303: Perform patterning on the channel shield layer by using a mask process to form the gate electrode 06 of the light sensor PD.

Step S304: Sequentially form a second insulation layer 311b and the first metal electrode layer 313, and perform patterning on the first metal electrode layer 312 by using a mask process to form a source electrode T01 and a drain electrode T02 of the TFT and the input electrode 01 and the output electrode 02 of the light sensor PD.

In the display panel, to form a photosensitive device PD, only step S303 needs to be added based on an original display panel process. Therefore, one mask process needs to be added. In a related technology, four mask processes need to be added. In comparison, three mask processes may be reduced in this application, thereby greatly reducing production costs. In addition, compared with a case in which the channel region is made of a semiconductor intrinsic material, the channel region of the light sensor is a P-type lightly doped region, and therefore impedance of the channel region may be reduced, thereby improving a photosensitive current and photosensitive efficiency of the light sensor.

Quantum efficiency (External Quantum Efficiency, EQE) of the light sensor of the display panel in the foregoing three embodiments and EQE of a light sensor with a PIN structure provided in a related technology are separately detected. EQE refers to accurate measurement of photosensitivity of a device. Table 1 shows detection results.

**Table 1**

|  |  | First doped region | Channel region | Second doped region | Quantity of gate electrodes | EQE |
|---|---|---|---|---|---|---|
| Related technology | | P+ | I | N+ | 0 | 2.65 |
|  |  |  |  |  | 1 | 3.2 |
| Example 1 | | P+ | P | N+ | 0 | 14.8 |
|  |  |  |  |  | 1 | 14.1 |
| Example 2 | | P+ | I | P+ | 0 | 4.0 |
|  |  |  |  |  | 1 | 4.8 |
| Example 3 | | P+ | P | P+ | 0 | 15.6 |
|  |  |  |  |  | 1 | 24.3 |

It can be learned from Table 1 that EQE of the light sensor in embodiments of this application is generally higher than that of the light sensor in the related technology, and EQE of the light sensor in Example 3 may be increased to more than 20% by adjusting a potential on the gate electrode.

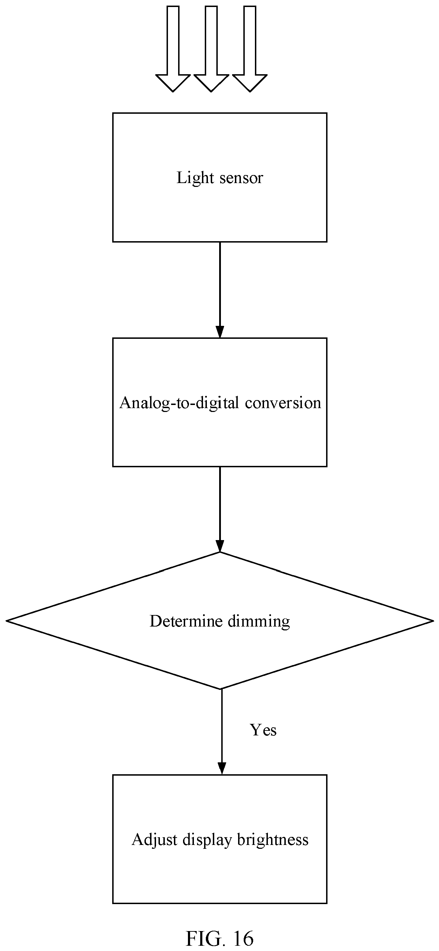

In actual application, the light sensor of the display panel provided in embodiments of this application may be configured to detect intensity of ambient light, or may be configured to detect intensity of light of a specific wavelength (for example, red light/green light/blue light/infrared light/ultraviolet light), to implement some specific functions. For example, screen brightness is adjusted by detecting ambient light. FIG. 16 shows an adjustment principle. The light sensor senses light intensity of a surrounding environment, converts an optical signal into an electrical signal, and outputs the electrical signal. An IC processes the output electrical signal, converts a current analog signal into a digital signal, and then reports the digital signal. The digital signal is processed by using an algorithm and then is multiplied by a corresponding coefficient to obtain a brightness value. The brightness value corresponds to a dimming order of a screen. Whether the screen needs to be dimmed is determined through judgment. If dimming is required, a driver chip outputs a corresponding drive current to adjust brightness of a display screen.

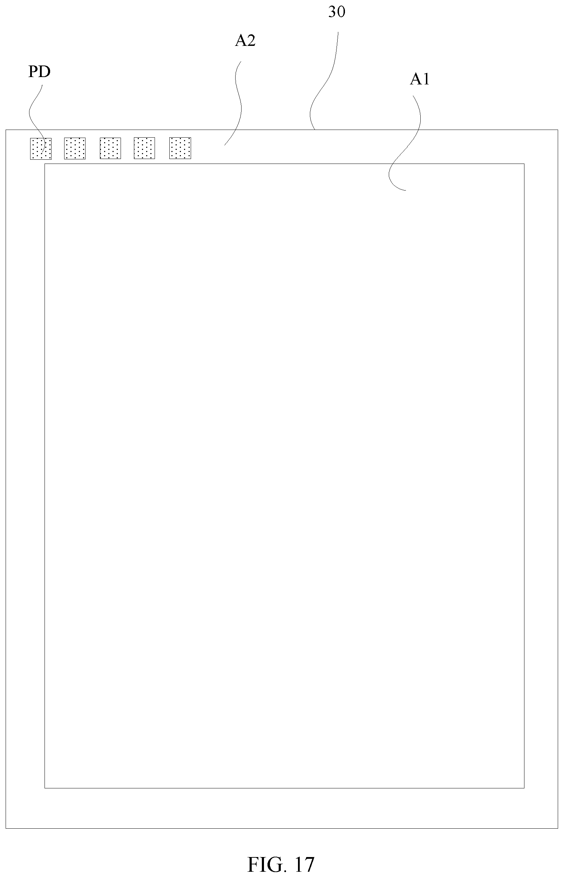

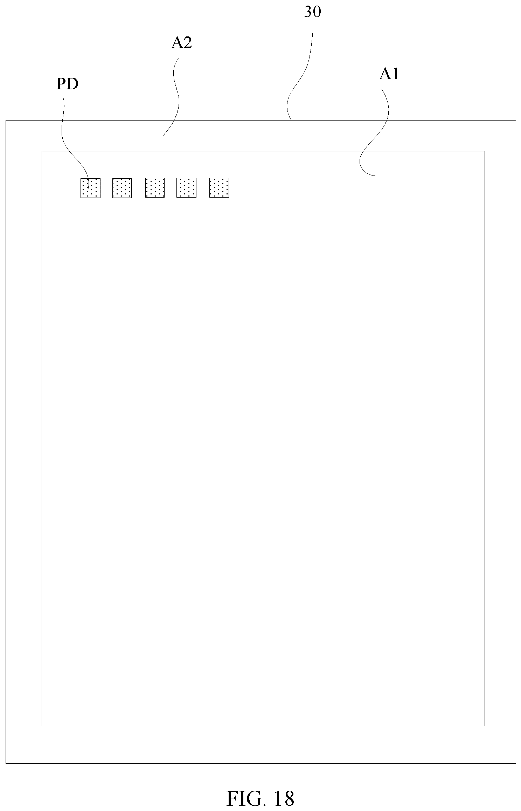

Refer to FIG. 17 and FIG. 18. During specific implementation, a display panel 30 may include a display area A1 and a non-display area A2. Pixels (not shown in the figure) for display are disposed in the display area A1, and a driver circuit and a trace (not shown in the figure) are generally disposed in the non-display area A2. A light sensor PD may be disposed in the display area A1, or may be disposed in the non-display area A2. This is not limited herein. When the light sensor PD is located in the non-display area A2, the light sensor PD may be disposed at a position in the non-display area A2 in which there is no driver circuit. This is not limited herein.

During specific implementation, as shown in FIG. 17, the display substrate may include a plurality of light sensor PDs, and the plurality of light sensor PDs may be all located in the non-display area A2; or as shown in FIG. 18, the plurality of light sensor PDs may be all located in the display area A1; or certainly, some of the plurality of light sensor PDs may be located in the non-display area A2, and the other part of the light sensor PDs may be located in the display area A1. This is not limited herein.

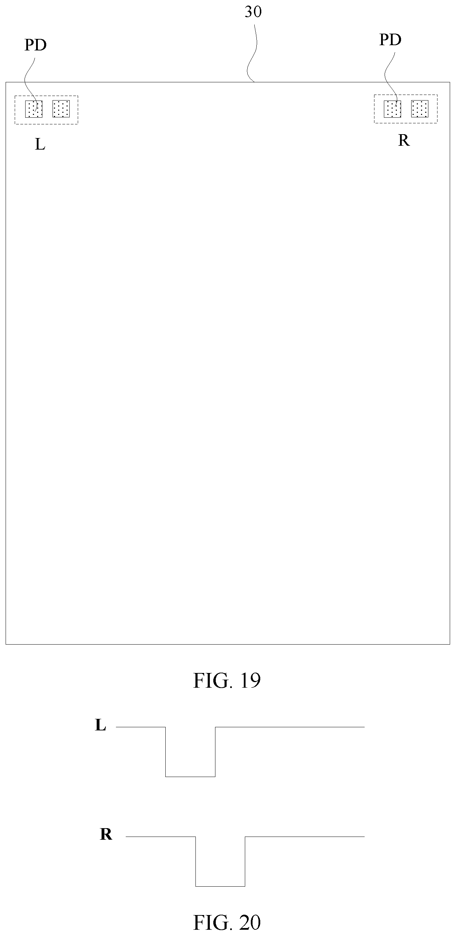

In actual application, in this application, a plurality of light sensors arranged in a matrix may be disposed in the display area, and a touch function may be implemented by detecting light intensity of each light sensor. Alternatively, a plurality of light sensors are disposed in a fingerprint recognition area, and a fingerprint recognition function is implemented by sensing relative light intensity between fingerprint valleys and fingerprint ridges at a fingerprint touch position. Alternatively, as shown in FIG. 19, at least one light sensor PD may be disposed on each of two opposite sides of the display panel 30. In the figure, a left side L and a right side R are used as an example. A gesture recognition function may be implemented by detecting time sequences of output signals of light sensor PDs on the two sides. FIG. 20 shows time sequences of output signals of the light sensor PDs on two sides. In FIG. 20, L represents an output signal of the left light sensor PD, and R represents an output signal of the right light sensor PD. When the output signal of the left light sensor PD becomes smaller, and then the output signal of the right light sensor PD becomes smaller, the left light sensor PD is blocked and then the right light sensor PD is blocked, so that a gesture is from left to right.

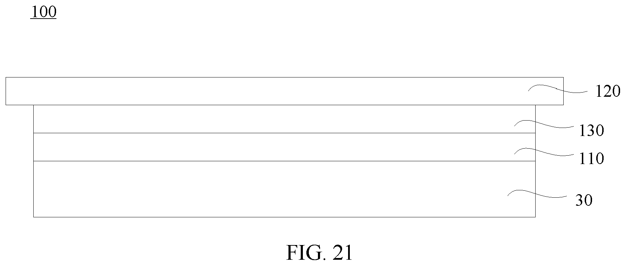

FIG. 21 is a schematic diagram of a cross-sectional structure of a display module according to an embodiment of this application. Refer to FIG. 21. A display module 100 provided in this embodiment of this application may include a display panel 30, a polarizer 110, and a cover layer 120 that are sequentially stacked. The display panel 30 may be any one of the foregoing display panels provided in embodiments of this application. Costs of the display panel 30 provided in embodiments of this application may be reduced when compared with a display panel provided in a related technology. Therefore, costs of the display module provided in this embodiment of this application may also be reduced.

For example, during specific implementation, as shown in FIG. 21, the cover layer 120 may be bonded to the polarizer 110 by using optical clear adhesive 130. This is not limited herein.

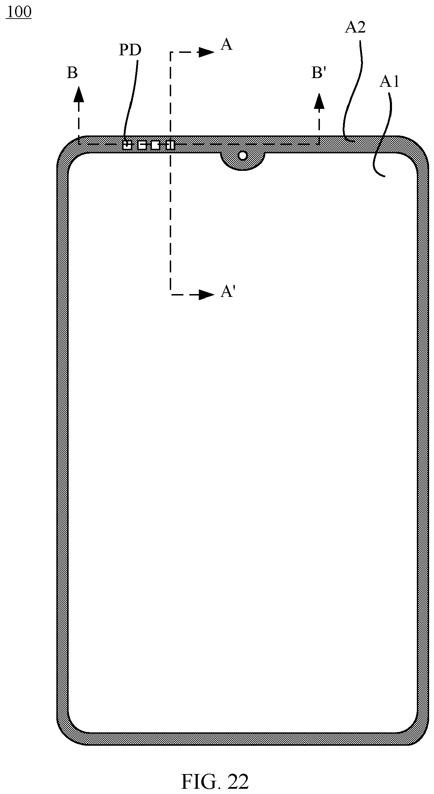

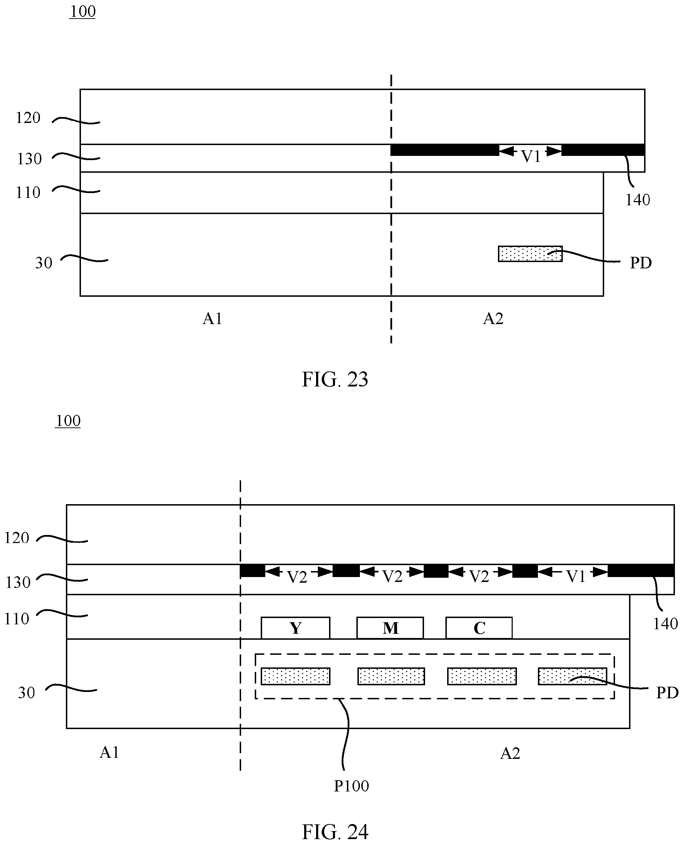

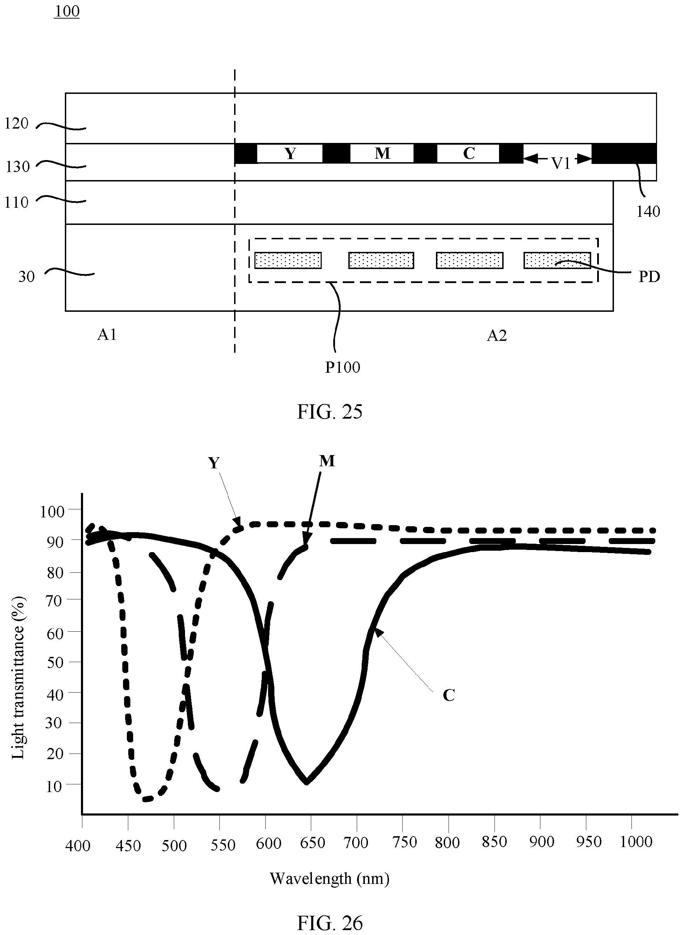

Refer to FIG. 22 to FIG. 25. FIG. 22 is a schematic diagram of a top-view structure of a display module according to an embodiment of this application. FIG. 23 is a schematic diagram of a cross-sectional structure of the display module shown in FIG. 22 along an AA' direction. FIG. 24 is a schematic diagram of a cross-sectional structure of the display module shown in FIG. 22 along a BB' direction. FIG. 25 is a schematic diagram of another cross-sectional structure of the display module shown in FIG. 22 along a BB' direction. In the display module 100, the display panel 30 has the display area A1 and the non-display area A2. A plurality of light sensors PDs are disposed in the non-display area A2 of the display panel 30. The display module 100 further includes a light shield ink layer 140 that is located between the display panel 30 and the cover layer 120 and at least one light filter film. Optionally, the at least one light filter film may include at least one yellow light filter film Y, at least one cyan light filter film C, and at least one magenta light filter film M. An orthographic projection of the light shield ink layer 140 on the display panel 30 covers the non-display area A2, and orthographic projections of each light filter film Y, C, and M on the display panel 30 are located in the non-display area A2. Each light filter film may correspond to at least one light sensor PD. For example, in FIG. 24 and FIG. 25, each yellow light filter film Y may correspond to at least one light sensor PD, each cyan light filter film C may correspond to at least one light sensor PD, and each magenta light filter film M may correspond to at least one light sensor PD. In FIG. 24 and FIG. 25, an example in which one light filter film corresponds to one light sensor is used for illustration.

The light shield ink layer 140 is used to shield the non-display area A2 of the display panel 30. The light shield ink layer 140 has at least one first opening V1 and at least one second opening corresponding to each light filter film, for example, at least one second opening V2 corresponding to each yellow light filter film Y, at least one second opening V2 corresponding to each cyan light filter film C, and at least one second opening V2 corresponding to each magenta light filter film M. Each first opening V1 may correspond to at least one light sensor PD.

Specifically, as shown in FIG. 24, orthographic projections of the light filter films Y, C, and M on the display panel 30 cover an orthographic projection of the at least one second opening V2 corresponding to the light filter films on the display panel 30. For example, an orthographic projection of the yellow light filter film Y on the display panel 30 covers an orthographic projection of the at least one second opening V2 corresponding to the yellow light filter film Y on the display panel 30, an orthographic projection of the cyan light filter film C on the display panel 30 covers an orthographic projection of the at least one second opening V2 corresponding to the cyan light filter film C on the display panel 30, and an orthographic projection of the magenta light filter film M on the display panel 30 covers an orthographic projection of the at least one second opening V2 corresponding to the magenta light filter film M on the display panel 30. In addition, orthographic projections of the light filter films Y, C, and M on the display panel 30 do not overlap with an orthographic projection of the first opening V1 on the display panel 30. "Nonoverlapping" herein means that two regions do not have any overlapping region.

During specific implementation, as shown in FIG. 25, the light filter films Y, C, and M and the light shield ink layer 140 may be disposed on a same layer. Certainly, as shown in FIG. 24, the light filter films Y, C, and M and the light shield ink layer 140 are disposed on different layers. This is not limited herein.

Refer to FIG. 24 and FIG. 25. For example, every four light sensors PDs may be used as a group of detection units P100, and at least one group of detection units P100 may be disposed in the non-display area A2. For each group of detection units P100, one light sensor PD corresponds to one first opening V1, the other three light sensor PDs correspond to three second openings V2, and the three second openings V2 respectively correspond to one yellow light filter film Y, one magenta light filter film M, and one cyan light filter film C. The yellow light filter film Y may enable yellow light to pass through, the magenta light filter film M may enable magenta light to pass through, and the cyan light filter film C may enable cyan light to pass through. FIG. 26 is a curve diagram of transmittances and wavelengths of the three types of light filter films. Therefore, intensity values of B (blue light), G (green light), R (red light), and NIR (infrared light) in ambient light may be calculated by detecting intensity of yellow light, cyan light, magenta light, and white light (that is, light passing through the first opening V1) in ambient light. The calculation formulas may be as follows:

$$B = W - Y \qquad \textcircled{1}$$

$$G = W - M \qquad \textcircled{2}$$

$$R = W - C \qquad \textcircled{3}$$

$$I = nY + M + Cn - 2W$$
$$= nG + R + In + nB + R + In + nB + G + In - 2 \times nB + G + R + In \qquad \textcircled{4}$$

In the foregoing formulas (1) to (4), B represents intensity of blue light, G represents intensity of green light, R represents intensity of red light, W represents intensity of white light, Y represents intensity of yellow light, M represents intensity of magenta light, C represents intensity of cyan light, and I represents intensity of infrared light.

Further, a function of detecting a color temperature of an environment may be further implemented by using the intensity values of B (blue light), G (green light), and R (red light). Formulas for calculating a chroma value x and a chroma value y of ambient light may satisfy the following formulas:

$$x = X/(X + Y + Z) \qquad (5)$$

$$y = Y/(X + Y + Z) \qquad (6)$$

$$X = \sum_{\lambda=380}^{780} L1(\lambda) \times R(\lambda) \times EQE1(\lambda) \qquad (7)$$

$$Y = \sum_{\lambda=380}^{780} L2(\lambda) \times G(\lambda) \times EQE2(\lambda) \qquad (8)$$

$$Z = \sum_{\lambda=380}^{780} L3(\lambda) \times B(\lambda) \times EQE3(\lambda) \qquad (9)$$

In formula (7), L1 ($\lambda$) represents an intensity value of red light, R ($\lambda$) represents a wavelength of red light, and EQE1 ($\lambda$) represents EQE of red light. In formula (8), L2 ($\lambda$) represents an intensity value of green light, G ($\lambda$) represents

a wavelength of green light, and EQE2 ($\lambda$) represents EQE of green light. In formula (9), L3 ($\lambda$) represents an intensity value of blue light, B ($\lambda$) represents a wavelength of blue light, and EQE3 ($\lambda$) represents EQE of blue light.

Table 2 shows a ratio of a low illumination detection capability between calculation of the intensity values of B (blue light), G (green light), and R (red light) in ambient light by detecting intensity of yellow light, cyan light, magenta light, and white light in ambient light in this application and direct detection of the intensity values of B (blue light), G (green light), and R (red light) in ambient light.

**Table 2**

| CMY:RGB * | Solar spectrum | Starlight spectrum |
|---|---|---|
| C:R | 2 | 2.5 |
| M:G | 2.1 | 4.4 |
| Y:B | 2.6 | 11.7 |

In Table 2, CMY represents data without an infrared light filter film, and RGB* represents data with an infrared light filter film in a conventional technology. It can be learned from the foregoing table that the low-illumination detection capability in this application can be improved by more than two times. Therefore, in this application, C/M/Y are used to replace R/G/B as measurement channels for a color temperature of an environment, so that an amount of light entering the light sensor may be increased by two times or more, thereby improving a sensing capability of the display module in low illumination.

In addition, because C/M/Y are used to replace R/G/B as measurement channels for a color temperature of an environment in this application, no infrared light channel needs to be manufactured, a quantity of light sensors and a quantity of analog-to-digital conversion channels of a chip may be reduced, and a process of manufacturing an infrared light filter film is not required, thereby reducing manufacturing complexity and costs of the display module.

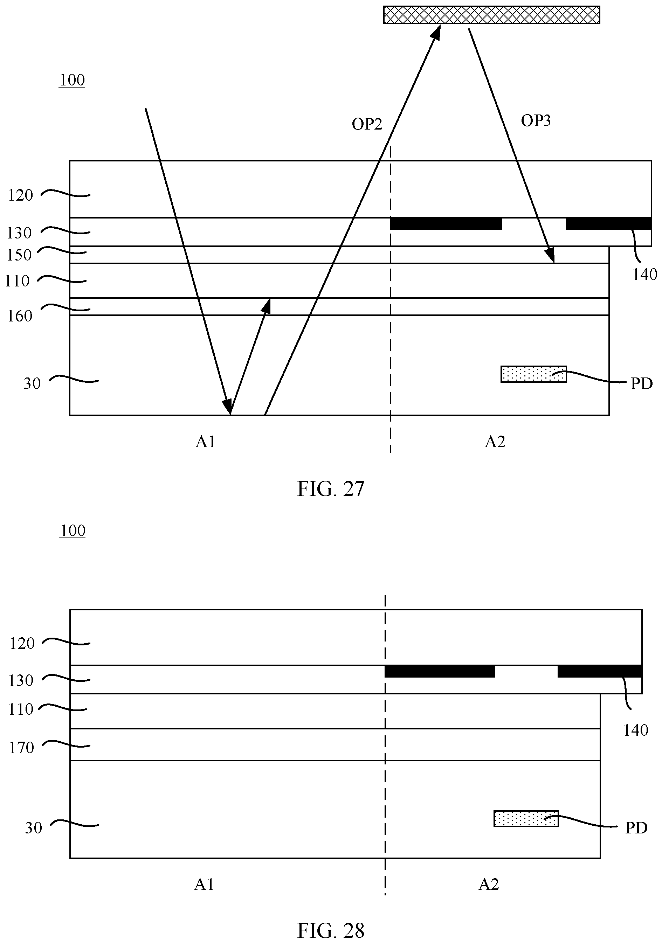

Refer to FIG. 27. Optionally, the display module 100 may further include a first quarter-wavelength delay layer 150 and a second quarter-wavelength delay layer 160 that are respectively located on two sides of the polarizer 110. When external ambient light OP1 passes through the polarizer 110 and becomes linear polarized light, the linear polarized light needs to pass through the second quarter-wavelength delay layer 160 twice after being reflected by a backplane of the display panel 30 and then illuminated to the polarizer 110, so that a polarization direction of the linear polarized light is perpendicular to a polarization direction of the polarizer 110, and the reflected linear polarized light cannot pass through the polarizer 110, thereby reducing reflectivity of the display module. Similarly, after light OP2 emitted by the display panel 30 is converted into linear polarized light by using the polarizer 110, light OP3 reflected by an object (for example, a face) also needs to pass through the first quarter-wavelength delay layer 150 twice, so that the polarization direction of the linear polarized light is perpendicular to the polarization direction of the polarizer 110, and the reflected linear polarized light cannot pass through the polarizer 110. This prevents the light emitted by the display panel 30 from being illuminated to the light sensor PD after the light is reflected by an object, which consequently causes a measurement error because the measured value deviates from a real environment.

Further, when an environment detected by the display module changes from a pure black environment to an environment with an illuminance of 02Lx, an output signal of the light sensor may change significantly. Therefore, the display module may improve the low-illuminance detection capability to 0.2lx.

Refer to FIG. 28. For example, the display module may further include a touch layer 170 located between the display panel 30 and the cover layer 120. During specific implementation, the touch layer 170 may be disposed between the display panel 30 and the polarizer 110. This is not limited herein.

This application further provides an electronic device, including any one of the foregoing display modules provided in embodiments of this application. A problem-resolving principle of the electronic device is similar to that of one of the foregoing display modules. Therefore, implementation of the electronic device may refer to implementation of the foregoing display module, and details are not described again.

During specific implementation, the electronic device in this application may detect a lighting condition of a current environment by using a light sensor integrated into a display panel, to adjust screen brightness of the display panel, make human eyes comfortable and not dazzling, and reduce power consumption of a display screen. For example, the electronic device is a mobile phone shown in FIG. 3, or a tablet, a portable computer, a display, a television, and the like shown in FIG. 4. The electronic device may further detect light of a specific wavelength (for example, red light/green light/blue light/infrared light/ultraviolet light) by using the light sensor integrated into the display panel, to implement more functions and applications, for example, color temperature detection, proximity light detection, and ultraviolet ray intensity detection. For example, a mobile phone, a tablet, or a watch, a computer, a monitoring screen, or a television shown in FIG. 5 senses light (for example, ultraviolet light/infrared light) of a specific wavelength in external ambient light, to implement a specific function. For example, infrared sensing may be used for proximity sensing, and ultraviolet sensing may be used to implement a UV index sensor.

It is clear that a person skilled in the art can make various modifications and variations to this application without departing from the scope of this application. This application is intended to cover these modifications and variations of this application provided that they fall within the scope of protection defined by the following claims and their equivalent technologies.

**Claims**

1. A display panel, comprising a display substrate and an opposite substrate that are disposed opposite to each other, wherein

   the display substrate comprises a substrate, and a display function film layer and at least one light sensor that are located on the substrate;
   the display function film layer at least comprises a semiconductor layer and a plurality of metal electrode layers that are stacked, and the semiconductor layer has a first P-type lightly doped region and a first P-type heavily doped region;
   the light sensor comprises an input electrode, an output electrode, and a channel region, a first doped region, and a second doped region that are disposed on a same layer as the semiconductor layer;
   the first doped region and the second doped region are respectively located on two sides of the channel region, the input electrode is electrically connected to the first doped region, and the output electrode is electrically connected to the second doped region;
   the first doped region, or the second doped region, or both have same material and same doping concentration as those of the first P-type heavily doped region; and
   the input electrode and the output electrode are respectively disposed on a same layer as at least one of the plurality of metal electrode layers.

2. The display panel according to claim 1, wherein the channel region of the light sensor has a same material and same doping concentration as those of the first P-type lightly doped region.

3. The display panel according to claim 1, wherein the channel region of the light sensor is made of an intrinsic semiconductor material.

4. The display panel according to any one of claims 1 to 3, wherein when the first doped region has a same material and same doping concentration as those of the first P-type heavily doped region, the second doped region is an N-type doped region; or
   when the second doped region has a same material and same doping concentration as those of the first P-type heavily doped region, the first doped region is an N-type doped region.

5. The display panel according to any one of claims 1 to 4, wherein the light sensor further comprises at least one gate electrode disposed on a same layer as one of the plurality of metal electrode layers, and an orthographic projection of the at least one gate electrode in the channel region partially overlaps the channel region.

6. The display panel according to claim 5, wherein the light sensor comprises one gate electrode, and the gate electrode is located on a side close to the output electrode.

7. The display panel according to any one of claims 1 to 6, wherein the display panel has a display area and a non-display area, and the display substrate comprises a plurality of light sensors; and

   the plurality of light sensors are located in the non-display area; or
   the plurality of light sensors are located in the display area; or
   some of the plurality of light sensors are located in the non-display area, and the other part of the light sensors are located in the display area.

8. A display module, comprising a display panel, a polarizer, and a cover layer that are sequentially stacked, wherein the display panel is the display panel according to any one of claims 1 to 7.

9. The display module according to claim 8, wherein the display panel has a display area and a non-display area, and a plurality of light sensors are disposed in the non-display area of the display panel;

the display module further comprises a light shield ink layer that is located between the display panel and the cover layer and at least one light filter film;

an orthographic projection of the light shield ink layer on the display panel covers the non-display area, an orthographic projection of each light filter film on the display panel is located in the non-display area, and each light filter film corresponds to at least one light sensor;

the light shield ink layer has at least one first opening and at least one second opening corresponding to each light filter film, and each first opening corresponds to at least one light sensor; and

orthographic projections of the light filter films on the display panel cover orthographic projections of the at least one second opening corresponding to the light filter films on the display panel, and the orthographic projections of the light filter films on the display panel do not overlap an orthographic projection of the first opening on the display panel.

10. The display module according to claim 9, wherein the at least one light filter film comprises at least one yellow light filter film, at least one cyan light filter film, and at least one magenta light filter film.

11. The display module according to claim 9, wherein the light filter film is disposed on a same layer as the light shield ink layer.

12. The display module according to any one of claims 8 to 11, wherein the display module further comprises a first quarter-wavelength delay layer and a second quarter-wavelength delay layer that are respectively located on two sides of the polarizer.

13. The display module according to any one of claims 8 to 12, wherein the display module further comprises a touch layer located between the display panel and the cover layer.

14. An electronic device, comprising the display module according to any one of claims 8 to 13.

Cover layer

Display panel

Photosensitive area

Light sensor

FIG. 1

4

2

3

P+   I   N+

1

FIG. 2

Light sensor

Adjust display brightness

FIG. 3

Light sensor

FIG. 4

FIG. 5

EP 4 300 584 A1

**10**

FIG. 6

**20**

FIG. 7

**30**

FIG. 8

30

01    06    02

32

311

31

311

310

04        03        05

PD

FIG. 9

30

01    06    06    02

32

311

31

311

310

04        03        05

PD

FIG. 10

Gate electrode voltage ◄──────────┐
                                  │
                          ┌───────┴───────┐
                          │ Gate electrode │
                          └───────────────┘

┌──────────────┬──────────────┬──────────────┬──────────────┐
│              │              │ +          − │              │
│ First doped  │   Channel    │ + Depletion− │ Second doped │
│   region     │   region     │ + region   − │   region     │
│              │              │ +          − │              │
└──────────────┴──────────────┴──────────────┴──────────────┘

                              Internal electric field direction

                              External electric field direction

Current

R

FIG. 11

EP 4 300 584 A1

PD

Gate electrode
voltage →

Equivalent resistance
in a depletion region

Output

FIG. 12

EP 4 300 584 A1

FIG. 13

FIG. 14

T01　　　　T06　　　　　T02　　　01　　　　06　　　　02

313 →

314 →

312 →

311b

311a

310

T04　T03　　　　T05　　　04　03　PD　　05

TFT

FIG. 15

Light sensor

Analog-to-digital conversion

Determine dimming

Yes

Adjust display brightness

FIG. 16

FIG. 17

FIG. 18

FIG. 19

FIG. 20

100

FIG. 21

FIG. 22

100

120

130

110

30

V1

140

PD

A1

A2

FIG. 23

100

120

130

110

30

V2

V2

V2

V1

140

Y

M

C

PD

A1

A2

P100

FIG. 24

FIG. 25

FIG. 26

100

OP2          OP3

120

130

150

110

160

140

30          PD

A1          A2

FIG. 27

100

120

130

110

170

140

30          PD

A1          A2

FIG. 28

INTERNATIONAL SEARCH REPORT

| International application No. |
|---|
| **PCT/CN2022/083422** |

**A. CLASSIFICATION OF SUBJECT MATTER**

H01L 27/32(2006.01)i; H01L 51/56(2006.01)i

According to International Patent Classification (IPC) or to both national classification and IPC

**B. FIELDS SEARCHED**

Minimum documentation searched (classification system followed by classification symbols)

H01L; G02F

Documentation searched other than minimum documentation to the extent that such documents are included in the fields searched

Electronic data base consulted during the international search (name of data base and, where practicable, search terms used)

CNTXT, ENTXT, DWPI, ENTXTC, CNKI: 显示, 面板, 基板, 光, 传感, 光敏, 感光, 光感, PD, 薄膜晶体管, TFT, 同?层, 同步, 同时, 减少, 降低, 掩膜, 掩模, 光罩, 偏光片, 盖板, 滤光膜, 滤光层, 油墨, display, panel, substrate, photo?sensor, photo?detect+, photo?sensit+, optical, photo, light, detect+, sensor, sensit+, thin film transistor, mask, polarized light, cover+, plate, filter, print+, ink

**C. DOCUMENTS CONSIDERED TO BE RELEVANT**

| Category* | Citation of document, with indication, where appropriate, of the relevant passages | Relevant to claim No. |
|---|---|---|
| PX | CN 113488507 A (HUAWEI TECHNOLOGIES CO., LTD.) 08 October 2021 (2021-10-08) description, paragraphs [0005]-[0164], and figures 1-28 | 1-14 |
| X | CN 1624556 A (TOSHIBA MATSUSHITA DISPLAY TEC) 08 June 2005 (2005-06-08) description, page 1, lines 9-13, and page 14, line 7 to page 24, line 6, and figures 26-42 | 1-14 |
| X | CN 102859693 A (SHARP CORP.) 02 January 2013 (2013-01-02) description, paragraphs [0055]-[0206], and figures 1A-13 | 1-14 |
| A | US 2009283772 A1 (AU OPTRONICS CORPORATION) 19 November 2009 (2009-11-19) entire document | 1-14 |

☐ Further documents are listed in the continuation of Box C.    ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **08 June 2022** | **14 June 2022** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2022/083422**

| Patent document cited in search report | | | Publication date (day/month/year) | Patent family member(s) | | | Publication date (day/month/year) |
|---|---|---|---|---|---|---|---|
| CN | 113488507 | A | 08 October 2021 | None | | | |
| CN | 1624556 | A | 08 June 2005 | SG | 109571 | A1 | 30 March 2005 |
| | | | | US | 2005045881 | A1 | 03 March 2005 |
| | | | | EP | 1511084 | A2 | 02 March 2005 |
| | | | | KR | 20050022358 | A | 07 March 2005 |
| | | | | TW | 200521540 | A | 01 July 2005 |
| | | | | US | 7164164 | B2 | 16 January 2007 |
| | | | | TW | 288266 | B1 | 11 October 2007 |
| | | | | SG | 109571 | B | 30 April 2007 |
| | | | | KR | 669270 | B1 | 16 January 2007 |
| | | | | JP | 4737956 | B2 | 03 August 2011 |
| | | | | JP | 2006003857 | A | 05 January 2006 |
| | | | | CN | 100340914 | C | 03 October 2007 |
| CN | 102859693 | A | 02 January 2013 | US | 2013037815 | A1 | 14 February 2013 |
| | | | | WO | 2011129441 | A1 | 20 October 2011 |
| | | | | EP | 2560207 | A1 | 20 February 2013 |
| | | | | JP | WO2011129441 | A1 | 18 July 2013 |
| | | | | US | 8803151 | B2 | 12 August 2014 |
| | | | | JP | 5512800 | B2 | 04 June 2014 |
| | | | | EP | 2560207 | A4 | 08 October 2014 |
| | | | | CN | 102859693 | B | 16 December 2015 |
| US | 2009283772 | A1 | 19 November 2009 | TW | 200949397 | A | 01 December 2009 |
| | | | | TW | I398707 | B | 11 June 2013 |

Form PCT/ISA/210 (patent family annex) (January 2015)

**REFERENCES CITED IN THE DESCRIPTION**

**Patent documents cited in the description**

- CN 202110342330